# EUROPEAN PATENT SPECIFICATION

(11) **EP 0 402 592 B1**
(45) Date of publication and mention of the grant of the patent: **21.08.1996**
(21) Application number: 90107407.0
(22) Date of filing: 19.04.1990
(51) Int. Cl.: H01L 23/485, H01L 21/60

(54) **Master slice semiconductor device and method of forming it**
Masterslice-Halbleiteranordnung und Verfahren zu ihrer Herstellung
Dispositif semi-conducteur à circuit prédiffusé et son procédé de fabrication

(30) Priority: 13.06.1989 JP 150190/89
(43) Date of publication of application: 19.12.1990
(73) Proprietor: KABUSHIKI KAISHA TOSHIBA, Kawasaki-shi, Kanagawa-ken 210 (JP)
(72) Inventor: Araki, Tomokazu, c/o Intellectual Property Div., Minato-ku, Tokyo 105 (JP)
(74) Representative: Lehn, Werner, Dipl.-Ing.

(56) References cited:
- EP-A- 0 257 437
- EP-A- 0 285 820
- PATENT ABSTRACTS OF JAPAN, vol. 9, no. 115 (E-315)[1838], 18th May 1985; & JP-A-60 4249 (NIPPON DENKI K.K.) 10-01-1985
- PATENT ABSTRACTS OF JAPAN, vol. 9, no. 248 (E-347)[1971], 4th October 1985; & JP-A-60 98 652 (MITSUBISHI) 01-06-1985

## Description

The present invention relates to master slice semiconductor devices contained in different types of packages and, more particularly, to a semiconductor device using master slice approach which allows easy identification of bonding pads which can fit specific type of package when bonding wires are connected to bonding pads, as well as to a method of forming such a device.

A semiconductor integrated circuit device (to be referred to as an LSI hereinafter) using an assembly master slice approach as a conventional method to improve the developing and production efficiencies of an LSI is known. In this approach, a large number of basic units such as transistors and gate circuits are formed on a semiconductor chip in advance, and wiring layers between the basic units are formed using a mask for forming wiring layers in the final step in the manufacturing process. Therefore, an LSI having a desired function can be manufactured within a short period of time.

In an LSI, e.g., 1M- or 4M-byte DRAM (dynamic random access memory) manufactured by the assembly master slice approach, electric pads called bonding pads are also formed by the master slice approach to be contained in various packages such as of DIP (dual in-line package) type, SOJ (small out-line J lead) type, or ZIP (zigzag in-line package) type. More specifically, bonding pads having the same outer shape are previously formed at positions which fit different types of packages, as known from JP-A-60 98652, and surface protective films each consisting of, e.g., an insulating film are deposited on the bonding pads, respectively. Thereafter, openings for bonding are formed in the surface protective films at all the bonding pad positions using a common mask which fits the different types of packages. Thereafter, only the bonding pads which fit a specific type of package are connected to lead electrodes called inner leads using bonding wires. Therefore, in the LSI of this type, bonding pads which are not bonded are present besides the pads respectively bonded to the lead electrodes.

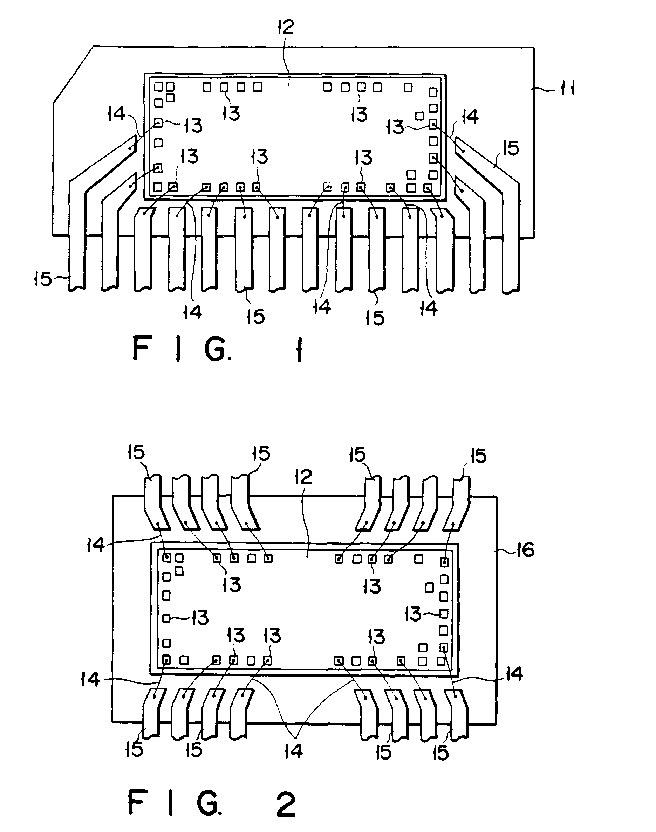

Fig. 1 is a plan view of a conventional LSI in a ZIP type package. In a peripheral portion of a chip 12 sealed in a package 11, a plurality of bonding pads 13 are arranged in advance at positions which fit different types of packages. As shown in Fig. 1, in the ZIP type package, the bonding pads 13 arranged along three sides of the chip 12 are connected to inner leads 15 through bonding wires 14, respectively.

Fig. 2 is a plan view of a conventional LSI in an SOJ type package. As shown in Fig. 2, in a package 16 of an SOJ type, the bonding pads 13 which are arranged along the two opposite sides of the chip 12 are mainly connected to the inner leads 15 through the bonding wires 14, respectively.

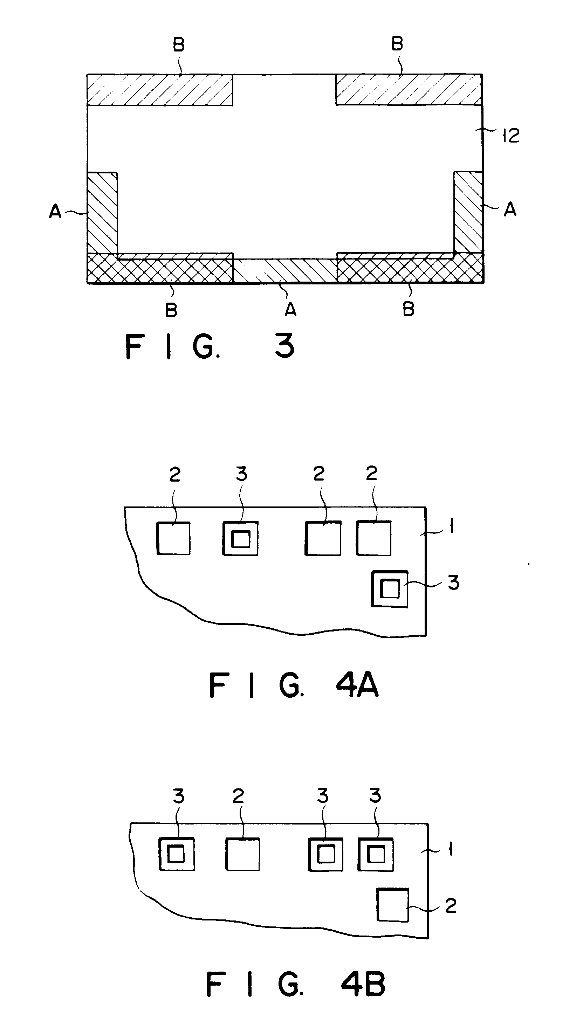

Fig. 3 is a plan view of the chip 12 commonly used for the ZIP type LSI shown in Fig. 1 and the SOJ type LSI shown in Fig. 2. In Fig. 3, a region A hatched by lines inclined from the upper left direction to the lower right direction serves as a pad region for the ZIP type package, and regions B hatched by lines inclined from the upper right direction to the lower left direction serve as pad regions for the SOJ type package. As shown in Fig. 3, the regions A and B partially overlap each other.

The above-mentioned bonding operation is often performed using a self-teaching bonding apparatus. In this apparatus, an operator observes the positions of the bonding pads 13 and the inner leads 15 by a microscope, and sets the bonding positions in the bonding apparatus with reference to a diagram of the bonding positions.

In the conventional semiconductor device using master slice approach, however, the bonding pads 13 having the same outer shape are arranged on a chip to fit the different types of packages. Therefore, an operator tends to misidentify pads to be bonded and pads not to be bonded upon observation using a microscope.

From JP-A-60-4249 it is known to discriminate between a bonding pad and a non-bonding pad in a master slice system. However, from this document it is not known to expose the interlayer insulating film for the purpose of discriminating both types of pads. More particularly, there is disclosed forming a discriminating pattern of a shape different from that of a bonding pad additionally on the pads for the purpose of discrimination. The discriminating pattern is formed on the non-bonding pad which is made of Al so that in case that an attempt is made to improperly connect the non-bonding pad, an electrical connection will occur.

From EP-A-0 285,820 it is known to provide terminal pads having two different shapes, in order to facilitate inspection.

It is the object of the present invention, to provide a semiconductor device using master slice approach which allows easy identification of pads to be bonded and pads not to be bonded and prevents bonding of the pads not to be bonded.

According to the present invention, this object is solved by a method and a device as defined in claims 1 and 3, respectively.

In the method in the step of notching the second bonding pads the hollow portions are preferably formed in the center of the second bonding pads.

Further features of the device are defined in claims 4 to 8.

According to the present invention, there is provided a semiconductor device using master slice approach wherein bonding pads which are bonded to lead electrodes are formed to have openings with a substantially square plane shape, and bonding pads which are not to be bonded to the lead electrodes are formed to have e.g., an opening with a substantially square plane shape and a notch in the center. The outer shape of the bonding pad can be changed depending on the packages which contain the semiconductor chip.

In the semiconductor device of the present invention, in the bonding pads arranged on a semiconductor chip, the shapes of the bonding pads to be bonded are different from those of the bonding pads which are not to be bonded depending on the types of packages to cause an operator to easily identify whether the bonding pads are to be bonded.

This invention can be more fully understood from the following detailed description when taken in conjunction with the accompanying drawings, in which:
Fig. 1 is a plan view showing an arrangement of a conventional semiconductor chip manufactured in an LSI using master slice assembly approach;
Fig. 2 is a plan view showing an arrangement of another conventional semiconductor chip manufactured in an LSI using master slice assembly approach;
Fig. 3 is a plan view showing regions in bonding pads respectively used in Figs. 1 and 2;
Fig. 4A is a plan view showing an arrangement of a semiconductor device according to an embodiment of the present invention;
Fig. 4B is a plan view showing an arrangement of a semiconductor device according to another embodiment of the present invention;
Fig. 5A is a plan view showing a detailed arrangement of bonding pads 2 shown in Figs. 4A and 4B;
Fig. 5B is a sectional view taken along the line V - V in Fig. 5A;
Fig. 6A is a plan view showing a detailed arrangement of bonding pads 3 shown in Figs. 4A and 4B; and
Fig. 6B is a sectional view taken along the line VT - VT in Fig. 6A.

There will now be described embodiments of this application with reference to the accompanying drawings.

A semiconductor device using master slice approach according to the present invention is manufactured as follows. On a semiconductor chip, bonding pads are formed at positions which fit different types of packages, and surface protective films are respectively deposited on the bonding pads. Thereafter, openings for bonding are respectively formed in the surface protective films at all the bonding pad positions using a common mask which can be used to the different types of packages. Before the semiconductor chip is sealed in the specific type of package, only required bonding pads are connected to corresponding inner leads, thus manufacturing the semiconductor device. In the present invention, the outer shape of bonding pads to be connected to the inner leads is different from that of the bonding pads not to be connected to the inner leads, depending on the types of packages which contain the chips.

An embodiment of the present invention will be described hereinafter with reference to the accompanying drawings.

Fig. 4A is a plan view showing an arrangement of a semiconductor device according to an embodiment of the present invention. Fig. 4A shows a semiconductor chip to be contained in a given type of package. A plurality of bonding pads are arranged on a semiconductor chip 1. The outer shape of each bonding pad 2 to which a corresponding bonding wire is connected is different from that of each bonding pad 3 to which no bonding wire is connected.

Fig. 4B is a plan view showing an arrangement of a semiconductor device according to another embodiment of the present invention. Fig. 4B shows a semiconductor chip to be contained in different type of package from the above type. A plurality of bonding pads are also arranged on a semiconductor chip 1 in this embodiment. The outer shape of each bonding pad 2 to which a corresponding bonding wire is connected is different from that of each bonding pad 3 to which no bonding wire is connected.

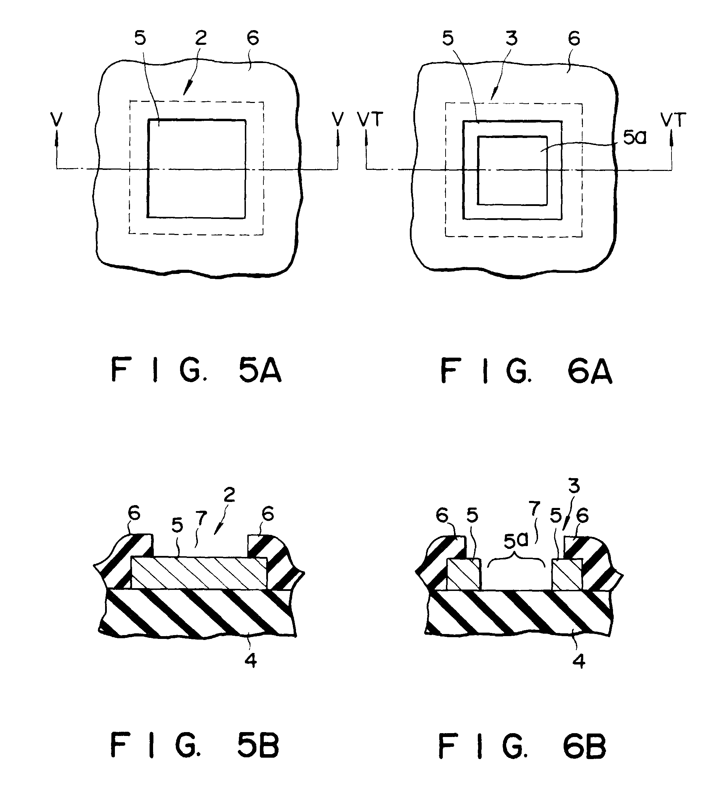

Fig. 5 shows a detailed arrangement of the bonding pad 2 to which the bonding wire is connected in Figs. 4A and 4B, in which Fig. 5A is a plan view of the bonding pad 2, and Fig. 5B is a sectional view taken along the line V - V in Fig. 5A. Fig. 6 shows a detailed arrangement of the bonding pad 3 to which no bonding wire is connected in Figs. 4A and 4B, in which Fig. 6A is a plan view of the bonding pad 3, and Fig. 6B is a sectional view taken along the line VI - VI in Fig. 6A.

Referring to Figs. 5 and 6, reference numeral 4 denotes an insulating interlayer film which consists of, e.g., a silicon oxide, and is formed on the surface of the semiconductor chip. A bonding pad 5 is formed on the insulating interlayer film 4. The bonding pad 5 is formed by depositing a conducting layer consisting of, e.g., aluminum on the entire surface of the insulating interlayer film 4, and patterning the resultant aluminum layer. A passivation film 6 consisting of an insulating film of for instance PSG (phospho-silicate glass) or PSiN (plasma silicon nitride) is deposited on the entire surface including the bonding pad 5. Openings 7 for bonding are formed in the passivation film 6 to correspond to bonding pad positions by the PEP (photoengraving process) using a common mask which fits different types of packages. The bonding pad 2 is formed to have a substantially square plane shape, as shown in Fig. 5A. In contrast to this, as shown in Fig. 6A, the bonding pad 3 is formed to have a substantially square plane shape with a notched portion, i.e., a hollow portion, 5a, e.g., in the center. The lower insulating interlayer film 4 is exposed through the hollow portions 5a.

Thus, the outer shape of the bonding pad 2 is different from that of the bonding pad 3. For this reason, when a bonding operation is performed using a self-teaching bonding apparatus, an operator can easily identify the bonding pad 2 to be bonded from the bonding pad 3 not to be bonded by a microscope, thus substantially preventing misidentification of the bonding pads.

In addition, even if an operator erroneously identifies bonding pads and thereafter bonding wires are connected to the bonding pads which are not to be bonded by a bonding apparatus, the lower insulating interlayer film 4 is exposed through the hollow portion 5a in the bonding pad 3, as shown in Figs. 6A and 6B, and thus the connection states of the bonding wires are insufficient. Therefore, these portions can be detected as defective portions upon a bonding precision test which is normally performed after the bonding operation.

The bonding pads 2 and 3 respectively shown in Figs. 5A and 5B and Figs. 6A and 6B are formed in the following manner. First, the insulating interlayer film 4 is deposited on the surface of the semiconductor chip 1. Then, a conducting layer such as an aluminum layer is deposited on the entire surface of the insulating interlayer film 4 by vacuum evaporation. When the aluminum layer is patterned using a mask depending on the types of packages, the bonding pads each having a shape shown in Figs. 5A and 5B or Figs. 6A and 6B are simultaneously formed. It is determined whether the hollow portion 5a is formed in each bonding pad in accordance with selection of a mask performed when the aluminum layer is deposited to form the bonding pad. Sequentially, the passivation film 6 is deposited on the entire surface. Then, the openings 7 for bonding are formed at each bonding pad position by selective etching using a mask which is common for all packages.

Note that the shape of the bonding pad which allows easy identification of bonding pads to be bonded and bonding pads not to be bonded is not limited to the above embodiments, and various methods can be employed, as a matter of course. For example, although the plane shape of the hollow portion 5a is square in the above embodiments, the portion 5a having an arbitrary shape such as a circle or a triangle can be formed. In addition, the size of the hollow portion 5a can also be changed within the range which allows identification, as needed. Although a case wherein an opening is formed in the passivation film 6 using a mask for forming an opening in the bonding pad which is common for the bonding pad 2 to be bonded and the bonding pad 3 not to be bonded has been described above, different masks for forming openings in the bonding pads may be used. Therefore, when at least the shape of the bonding pad can be easily identified by an operator, misidentification by the operator can be prevented.

As described above, according to the present invention, there is provided a semiconductor device using master slice approach which allows easy identification of bonding pads to be bonded and bonding pads not to be bonded.

Reference signs in the claims are intended for better understanding and shall not limit the scope.

## Claims

1. A method of forming a master slice semiconductor device, comprising the steps of:
forming an insulating interlayer (4) on a surface of a semiconductor chip (1);
forming an electrically conductive layer (5) on the entire surface of the insulating interlayer (4);
forming bonding pads at predetermined positions of the semiconductor device (1) which fit different types of device mounting packages, the step of forming said bonding pads including the steps of:
forming first bonding pads (2) to be bonded to corresponding lead electrodes of a desired type of package and second bonding pads (3) not to be bonded to lead electrodes, by patterning the conductive layer by using a mask depending on the desired type of package;
respectively notching the second bonding pads (3) to form hollow portions (5a) by using said mask so as to expose the insulating interlayer (4) through said hollow portions (5a); and
removing said mask;
depositing a surface protective film (6) on the resulting surface of the semiconductor chip (1);
forming openings (7) in said surface protective film (6) at the positions of said bonding pads by a photoengraving process using mask means fitting the different types of packages at the positions of the bonding pads so as to expose all bonding pads and also the insulating interlayer (4) through said hollow portions; and
bonding only the first bonding pads (2), when the semiconductor device is contained in a specific type of package, to corresponding lead electrodes of said type of package.

2. The method according to claim 1,
wherein in the step of notching the second bonding pads (3) the hollow portions (5a) are formed in the center of the second bonding pads.

3. A master slice semiconductor device comprising:
a semiconductor chip (1);
an insulating interlayer (4) formed on a surface of the semiconductor chip (1);
a plurality of bonding pads, including first and second bonding pads (2, 3) formed on said insulating interlayer (4) at predetermined positions, and fitting different types of device mounting packages, wherein
said first bonding pads (2) being located for bonding them respectively to corresponding lead electrodes of a specific type of device mounting package when the semiconductor device is contained in said type of package, and
said second bonding pads (3) being for not bonding to lead electrodes of said specific type of package, and each having a hollow portion (5a) exposing said insulating interlayer (4);
a surface protective film (6) formed on the resulting surface of the semiconductor device;
and a plurality of bonding openings (7) formed in said surface protective film (6) above said first bonding pads (2) and said second bonding pads (3), respectively, so as to expose all of said bonding pads (2, 3) and also said insulating interlayer (4) through said hollow portions (5a).

4. The semiconductor device according to claim 3,
**characterized** in that said hollow portions (5a) of said second bonding pads (3) respectively are formed by centrally arranged notched portions.

5. The semiconductor device according to claim 4,
**characterized** in that said hollow portions (5a) are square-shaped.

6. The semiconductor device according to claim 4,
**characterized** in that said hollow portions (5a) are circular.

7. The semiconductor device according to claim 4,
**characterized** in that said hollow portions (5a) are triangle-shaped.

8. The semiconductor device according to anyone of claims 4 to 7,
**characterized** in that said bonding openings (7) respectively expose only a portion of said bonding pads (2, 3).

## Patentansprüche

1. Verfahren zur Herstellung einer Master-slice-Halbleitervorrichtung, das folgende Schritte aufweist:
- Bilden einer isolierenden Zwischenschicht (4) auf einer Oberfläche eines Halbleiterchips (1);
- Bilden einer elektrisch leitenden Schicht (5) auf der gesamten Oberfläche der isolierenden Zwischenschicht (4);
- Bilden von Bondierungsflecken an vorbestimmten Positionen der Halbleitervorrichtung (1), die für unterschiedliche Typen von Vorrichtungsmontagegehäusen paßt, wobei der Schritt der Bildung der Bondierungsflecken folgende Schritte umfaßt:
- Bilden erster Bondierungflecken (2), die an entsprechende Anschlußleitungselektroden eines gewünschten Packungstyps bondiert werden sollen, und zweite Bondierungsflecken (3), die nicht an Anschlußleitungselektroden bondiert werden sollen, durch Bemustern der leitenden Schicht unter Benutzung einer Maske je nach dem gewünschten Gehäusetyp;
- entsprechendes Schlitzen der zweiten Bondierungsflecken (3), um hohle Abschnitte (5a) zu bilden unter Benutzung der genannten Maske, so daß die isolierende Zwischenschicht (4) durch die hohlen Abschnitte (5a) exponiert wird; und
- Beseitigen der Maske;
- Aufbringen eines Oberflächenschutzfilms (6) auf der sich ergebenden Oberfläche des Halbleiterchips (1);
- Bilden von Öffnungen (7) im Oberflächenschutzfilm (6) in den Positionen der Bondierungsflecken durch einen Fotogravierprozeß unter Benutzung von Masken, die für die verschiedenen Gehäusetypen passen, so daß alle Bondierungsflecken und auch die isolierende Zwischenschicht (4) durch die hohlen Abschnitte exponiert werden; und
- Bondieren nur der ersten Bondierungsflecken (2), wenn die Halbleitervorrichtung in einem spezifischen Gehäusetyp untergebracht wird, an entsprechende Anschlußleitungselektroden des Gehäusetyps.

2. Verfahren nach Anspruch 1, bei dem im Schritt des Schlitzens der zweiten Bondierungsflecken (3) die hohlen Abschnitte (5a) in der Mitte der zweiten Bondierungsflecken gebildet werden.

3. Master-slice-Halbleitervorrichtung, aufweisend:
- einen Halbleiterchip (1);
- eine isolierende Zwischenschicht (4), die auf einer Oberfläche des Halbleiterchips (1) gebildet ist;
- eine Vielzahl von Bondierungsflecken, die erste und zweite Bondierungsflecken (2, 3) umfassen, welche auf der isolierenden Zwischenschicht (4) an vorbestimmten Positionen gebildet sind, und die für unterschiedliche Vorrichtungsmontagegehäuse passen, wobei
- die ersten Bondierungsflecken (2) zum Bondieren derselben jeweils an entsprechenden Anschlußleitungselektroden eines spezifischen Typs eines Vorrichtungsmontagegehäuses plaziert sind, wenn die Halbleitervorrichtung in dem Gehäusetyp untergebracht wird, und
- die zweiten Bondierungsflecken (3) nicht für das Bondieren an Anschlußleitungselektroden des spezifischen Gehäusetyps bestimmt sind, und wobei jeder Fleck einen hohlen Abschnitt (5a) aufweist, der die isolierende Zwischenschicht (4) exponiert;
- einen Oberflächenschutzfilm (6), der auf der sich ergebenden Oberfläche der Halbleitervorrichtung gebildet ist;
- und eine Vielzahl von Bondieröffnungen (7), die im Oberflächenschutzfilm (6) jeweils über den ersten Bondierungsflecken (2) und den zweiten Bondierungsflecken (3) gebildet sind, so daß alle Bondierungsflecken (2, 3) und auch die isolierende Zwischenschicht (4) durch die hohlen Abschnitte (5a) exponiert werden.

4. Halbleitervorrichtung nach Anspruch 3,
dadurch **gekennzeichnet,** daß hohle Abschnitte (5a) der zweiten Bondierungsflecken (3) jeweils durch mittig angeordnete geschlitzte Abschnitte gebildet sind.

5. Halbleitervorrichtung nach Anspruch 4,
dadurch **gekennzeichnet**, daß die hohlen Abschnitte (5a) quadratisch sind.

6. Halbleitervorrichtung nach Anspruch 4,
dadurch **gekennzeichnet**, daß die hohlen Abschnitte (5a) kreisförmig sind.

7. Halbleitervorrichtung nach Anspruch 4,
dadurch **gekennzeichnet**, daß die hohlen Abschnitte (5a) dreieckig sind.

8. Halbleitervorrichtung nach nach irgendeinem der Ansprüche 4 bis 7,
dadurch **gekennzeichnet**, daß die Bondieröffnungen (7) jeweils nur einen Abschnitt der Bondierungsflecken (2, 3) exponieren.

## Revendications

1. Procédé de fabrication d'un dispositif semi-conducteur à circuit prédiffusé, comprenant les étapes de :
élaboration d'une inter-couche d'isolation (4) sur une surface d'une puce semi-conductrice (1) ;
élaboration d'une couche électriquement conductrice (5) sur la surface entière de l'inter-couche d'isolation (4) ;
élaboration de plages de câblage à des positions prédéterminées du dispositif semi-conducteur (1) qui correspondent aux différents types de boîtiers de montage de dispositif, l'étape de fabrication desdites plages de câblage comprenant les étapes de :
élaboration des premières plages de câblage (2) à câbler sur des électrodes de sortie correspondantes d'un type de boîtier voulu et des secondes plages de câblage (3) à ne pas câbler aux électrodes de sortie, par formation de motifs sur la couche conductrice en utilisant un masque en fonction du type de boîtier voulu ;
évidage respectivement des secondes plages de câblage (3) pour former des parties creuses (5a) en utilisant ledit masque afin d'exposer l'inter-couche d'isolation (4) via des parties creuses (5a) ; et
enlèvement dudit masque ;
déposition d'une couche protectrice de surface (6) sur la surface résultante de la puce semi-conductrice (1) ;
élaboration des ouvertures (7) dans ladite couche de protection de surface (6) à des positions desdites plages de câblage par un procédé de photogravure en utilisant un dispositif de masque correspondant aux différents types de boîtiers à des positions de plage de câblage afin d'exposer toutes les plages de câblage et aussi les inter-couches d'isolation (4) via lesdites parties creuses ; et
câblage seulement des premières plages de câblage (2), lorsque le dispositif semi-conducteur est contenu dans un type de boîtiers spécifique, aux électrodes de sortie correspondantes dudit type de boîtiers.

2. Procédé selon la revendication 1, dans lequel l'étape d'évidage des secondes plages de câblage (3) les parties creuses (5a) sont formées au centre des secondes plages de câblage.

3. Dispositif semi-conducteur à circuit prédiffusé comprenant :
une puce semi-conductrice (1) ;
une inter-couche d'isolation (4) formée sur une surface de la puce semi-conductrice (1) ;
une pluralité de plages de câblage, comprenant des première et seconde plages de câblage (2, 3) formées sur ladite inter-couche d'isolation (4) à des positions prédéterminées, et correspondant aux différents types de boîtiers de montage du dispositif, où
lesdites premières plages de câblage (2) étant repérées pour les câbler respectivement aux électrodes de sortie correspondantes d'un type de boîtier de montage de dispositif spécifique lorsque le dispositif semi-conducteur est contenu dans ledit type de boîtier ; et
lesdites secondes plages de câblage (3) étant repérées pour ne pas être câblées aux électrodes de sortie dudit type de boîtier spécifique, et chacune ayant une partie creuse (5a) exposant ladite inter-couche d'isolation (4) ;
une couche protectrice de surface (6) formée sur la surface résultante du dispositif semi-conducteur ;
et une pluralité d'ouvertures de câblage (7) formées dans ladite couche de surface protectrice (6) au-dessus desdites premières plages de câblage (2) et desdites secondes plages de câblage (3), respectivement, afin d'exposer toutes lesdites plages de câblage (2, 3) et aussi ladite inter-couche d'isolation (4) via lesdites parties creuses (5a).

4. Dispositif semi-conducteur selon la revendication 3, caractérisé en ce que lesdites parties creuses (5a) desdites secondes plages de câblage (3) sont formées respectivement sur des parties évidées disposées centralement.

5. Dispositif semi-conducteur selon la revendication 4, caractérisé en ce que lesdites parties creuses (5a) sont de forme carrée.

6. Dispositif semi-conducteur selon la revendication 4 caractérisé en ce que lesdites parties creuses (5a) sont circulaires.

7. Dispositif semi-conducteur selon la revendication 4, caractérisé en ce que lesdites parties creuses (5a) sont de forme triangulaire.

8. Dispositif semi-conducteur selon l'une quelconque des revendications 4 à 7, caractérisé en ce que lesdites ouvertures de câblage (7) n'exposent respectivement qu'une partie desdites plages de câblage (2, 3).
